# EUROPÄISCHE PATENTSCHRIFT

(11) **EP 2 342 366 B1**
(45) Veröffentlichungstag und Bekanntmachung des Hinweises auf die Patenterteilung: **28.02.2018**
(21) Anmeldenummer: 09744030.9
(22) Anmeldetag: 03.09.2009
(51) Int. Cl.: C23C 28/00, C23C 16/26, C23C 16/56

(54) **METALL/CNT- UND/ODER FULLEREN-KOMPOSIT-BESCHICHTUNG AUF BANDWERKSTOFFEN**
METAL/CNT AND/OR FULLERENE COMPOSITE COATING ON STRIP MATERIALS
REVÊTEMENT DE MÉTAL/CNT ET/OU REVÊTEMENT COMPOSITE

(30) Priorität: 24.10.2008 DE 102008053030
(43) Veröffentlichungstag der Anmeldung: 13.07.2011
(73) Patentinhaber: KME Germany GmbH & Co. KG, 49074 Osnabrück (DE); TE Connectivity Germany GmbH, 64625 Bensheim (DE); Wieland-Werke AG, 89079 Ulm (DE)
(72) Erfinder: SCHMIDT, Helge, 67346 Speyer (DE); BURESCH, Isabell, 89257 Illertissen (DE); ADLER, Udo, 56075 Koblenz (DE); RODE, Dirk, 49088 Osnabrück (DE); PRIGGEMEYER, Sonja, 49134 Wallenhorst (DE)
(74) Vertreter: Grünecker Patent- und Rechtsanwälte PartG mbB
(86) Internationale Anmeldenummer: PCT/DE2009/001236
(87) Internationale Veröffentlichungsnummer: WO 2010/045904

(56) Entgegenhaltungen:
- US-A1- 2007 116 957
- US-A1- 2008 241 545
- BULT J ET AL: "Electrical switching using compliant metal infiltrated Multi-Wall nanotube arrays" MATERIALS RESEARCH SOCIETY SYMPOSIUM PROCEEDINGS - MATERIALS RESEARCH SOCIETY SYMPOSIUM PROCEEDINGS - NANOSCALE TRIBOLOGY-IMPACT FOR MATERIALS AND DEVICES 24-28 MARCH 2008 MATERIALS RESEARCH SOCIETY USA, Bd. 1085, 30. Dezember 2010 (2010-12-30), Seiten 13-18, XP002577934
- DATABASE COMPENDEX [Online] ENGINEERING INFORMATION, INC., NEW YORK, NY, US 2008 BULT J ET AL: 'Electrical switching using compliant metal infiltrated Multi-Wall nanotube arrays' Database accession no. E20092712158532 & MATERIALS RESEARCH SOCIETY SYMPOSIUM PROCEEDINGS - MATERIALS RESEARCH SOCIETY SYMPOSIUM PROCEEDINGS - NANOSCALE TRIBOLOGY-IMPACT FOR MATERIALS AND DEVICES 2008 MATERIALS RESEARCH SOCIETY USA, vol. 1085, 2008, pages 13-18,

## Beschreibung

Die Erfindung betrifft eine Metall/Kohlenstoff-Nanoröhren (CNT)- und/oder Fulleren-Komposit-Beschichtung auf Metallbändern, die einen verbesserten Reibwert, einen guten Kontaktübergangswiderstand, eine gute Reibkorrosionsbeständigkeit, eine gute Verschleißbeständigkeit und gute Umformbarkeit aufweist. Die Erfindung betrifft ferner ein Verfahren zur Herstellung eines erfindungsgemäß beschichteten Metallbandes.

Kohlenstoff-Nanoröhren (CNTs) wurden von Sumio lijama im Jahre 1991 entdeckt (siehe S. lijama, Nature, 1991, 354, 56). lijama fand im Ruß eines Fullerengenerators unter bestimmten Reaktionsbedingungen röhrenartige Gebilde von nur wenigen 10 nm Durchmesser, aber bis zu einigen Mikrometern Länge. Die von ihm gefundenen Verbindungen bestanden aus mehreren konzentrischen Graphitröhren, welche die Bezeichnung mehrwandige Kohlenstoff-Nanoröhren (multi-wall carbon nanotubes, MWCNTs) bekamen. Kurz darauf wurden von lijama und Ichihashi einwandige CNTs von etwa nur 1 nm Durchmesser gefunden, welche entsprechend als Single-Wall Carbon-Nanotubes (SWCNTs) bezeichnet wurden (s. S. lijama, T. Ichihashi, Nature, 1993, 363, 6430).

Zu den herausragenden Eigenschaften der CNTs zählen z.B. ihre mechanische Zugfestigkeit und Steifheit von etwa 40 GPa bzw. 1 TPa (20- bzw. 5-mal höher als die von Stahl).

Bei den CNTs existieren sowohl leitende als auch halbleitende Materialien. Die Kohlenstoff-Nanoröhren gehören zu der Familie der Fullerene und besitzen einen Durchmesser von 1 nm bis einigen 100 nm. Kohlenstoff-Nanoröhren sind mikroskopisch kleine röhrenförmige Gebilde (molekulare Nanoröhren) aus Kohlenstoff. Ihre Wände bestehen wie die der Fullerene oder wie die Ebenen des Graphits nur aus Kohlenstoff, wobei die Kohlenstoffatome eine wabenartige Struktur mit sechs Ecken und jeweils drei Bindungspartnern einnehmen (vorgegeben durch die sp²-Hybridisierung). Der Durchmesser der Röhren liegt meist im Bereich von 1 bis 50 nm, wobei aber auch Röhren mit nur 0,4 nm Durchmesser hergestellt wurden. Längen von mehreren Millimetern für einzelne Röhren und bis zu 20 cm für Röhrenbündel wurden bereits erreicht.

Die Synthese der Kohlenstoff-Nanoröhren erfolgt gewöhnlich durch Abscheidung von Kohlenstoff aus der Gasphase oder einem Plasma. Für die Elektronikindustrie sind vor allem die Strombelastbarkeit und die Wärmeleitfähigkeit interessant. Die Strombelastbarkeit liegt schätzungsweise 1000-mal höher als bei Kupferdrähten, die Wärmeleitfähigkeit ist bei Raumtemperatur mit 6000 W/m * K beinahe doppelt so hoch wie die von Diamant, dem besten natürlich vorkommenden Wärmeleiter.

Wie oben bereits ausgeführt gehören die Kohlenstoff-Nanoröhren zur Gruppe der Fullerene. Als Fullerene werden sphärische Moleküle aus Kohlenstoffatomen mit hoher Symmetrie bezeichnet, welche die dritte Element-Modifikation des Kohlenstoffs (neben Diamant und Graphit) darstellen. Die Herstellung der Fullerene erfolgt gewöhnlich durch Verdampfen von Graphit unter reduziertem Druck und unter einer Schutgasatmosphäre (z.B. Argon) mit einer Widerstandsheizung oder im Lichtbogen. Als Nebenprodukt entstehen häufig die bereits oben besprochenen Kohlenstoff-Nanoröhren. Fullerene haben halbleitende bis supraleitende Eigenschaften.

Im Stand der Technik ist bekannt, dass Kohlenstoff-Nanoröhren mit herkömmlichem Kunststoff gemischt werden. Dadurch werden die mechanischen Eigenschaften der Kunststoffe stark verbessert. Außerdem ist es möglich, elektrisch leitende Kunststoffe herzustellen, beispielsweise wurden Nanoröhren bereits zur Leitfähigmachung von Antistatikfolien verwendet.

Bult et al. in "Electrical switching using compliant metal infiltrated Multi-Wall nanotube arrays",MATERIALS RESEARCH SOCIETY SYMPOSIUM PROCEEDINGS - NANOSCALE TRIBOLOGY-IMPACT FOR MATERIALS AND DEVICES 24-28 MARCH 2008 MATERIALS RESEARCH SOCIETY USA, Bd. 1085, 30. Dezember 201, Seiten 13-18, offenbart metallische Substrate mit einer Beschichtung aus Kohlenstoff-Nanoröhren, die mit Silber oder Gold infiltriert sind.

Elektromechanische Bauelemente wie beispielsweise Steckverbinder, Schalter, Relaisfedern, direkt steckbare Stanzgitter und dergleichen haben in der heutigen Ausführung mit einer Zinn- oder Silber oder Ni-Beschichtung häufig ein Problem eines schlechten Reibwerts und/oder Kontaktübergangswiderstands, einer geringen Verschleißbeständigkeit und/oder einer schlechten Umformbarkeit. Der Einsatz von Kohlenstoff-Nanoröhren und/oder Fullerenen zur Verbesserung dieser Eigenschaften ist im Stand der Technik bisher nicht bekannt.
Die Aufgabe der vorliegenden Erfindung lag somit in der Bereitstellung eines elektromechanischen Bauteils, das die oben genannten Nachteile überwindet, also einen verbesserten Reibwert und/oder einen guten Kontaktübergangswiderstand und/oder eine gute Verschleißbeständigkeit und/oder eine gute Umformbarkeit aufweist.
Die Aufgabe wird gelöst durch ein Metallband, umfassend eine Beschichtung aus Kohlenstoff-Nanoröhren und/oder Fullerenen und Metall.
Als Metallband im Sinne dieser Erfindung wird vorzugsweise ein Metallband bzw. ein elektromechanisches Bauteil verstanden, das vorzugsweise aus Kupfer und/oder Kupferlegierungen, Aluminium und/oder Aluminiumlegierungen oder Eisen und/oder Eisenlegierungen besteht.
Vorzugsweise umfasst das Metallband eine Diffusionssperrschicht, welche vorteilhafterweise auf beiden Seiten des Metallbandes aufgebracht ist. Das Metallband soll ein Nicht-Isolator sein. Bevorzugt umfasst die Diffusionssperrschicht deshalb ein Übergangsmetall bzw. besteht aus diesem. Bevorzugte Übergangsmetalle sind beispielsweise Mo, B, Co, Fe/Ni, Cr, Ti, W oder Ce.
Die Kohlenstoff-Nanoröhren sind säulenartig auf dem Metallband angeordnet, was durch das nachstehend beschriebene erfindungsgemäße Verfahren erreicht werden kann. Die Kohlenstoff-Nanoröhren können einwandige oder mehrwandige Kohlenstoff-Nanoröhren sein, was ebenfalls durch das erfindungsgemäße Verfahren gesteuert werden kann. Die Fullerene sind bevorzugt in Form von Kugeln auf dem Metallband angeordnet.

Die Beschichtung enthält auch Graphene. Als Graphene bezeichnet man monoatomare Lagen von sp²-hybridisierten Kohlenstoffatomen. Graphene zeigen eine sehr gute elektrische und thermische Leitfähigkeit entlang ihrer Ebene. Die Darstellung von Graphen erfolgt durch Aufspalten von Graphit in seine Basalebenen. Dabei wird zunächst Sauerstoff interkaliert. Der Sauerstoff reagiert partiell mit dem Kohlenstoff und führt zu einer gegenseitigen Abstoßung der Schichten. Anschließend werden die Graphene suspendiert und je nach Verwendungszweck zum Beispiel in Polymere eingebettet oder wie in der vorliegenden Erfindung als Beschichtungskomponente für ein Metallband.
Eine weitere Möglichkeit der Darstellung einzelner Graphen-Lagen ist das Erhitzen hexagonaler Siliciumcarbid-Oberflächen auf Temperaturen oberhalb 1400 °C. Aufgrund des höheren Dampfdruckes des Siliciums evaporieren die Silicium-Atome schneller als die Kohlenstoff-Atome. Auf der Oberfläche bilden sich dann dünne Schichten einkristallinen Graphits, die aus wenigen Graphen-Monolagen bestehen.
In einer bevorzugten Ausführungsform bilden die Graphene und/oder Kohlenstoff-Nanoröhren und/oder Fullerenen ein Komposit. Das bedeutet, dass die Graphene mit Kohlenstoff-Nanoröhren, die Graphene mit Fullerenen, die Fullerene mit Kohlenstoff-Nanoröhren oder alle Komponenten zusammen ein Komposit bilden können. Besonders bevorzugt sind die Graphene orthogonal auf den Kohlenstoff-Nanoröhren und/oder Fullerenen angeordnet, wobei sie beispielsweise den Abschluss einer Röhre in axialer Richtung darstellen, oder die Graphene und Fullerene sind orthogonal auf den Kohlenstoff-Nanoröhren angeordnet. Eine orthogonale Anordnung von Graphenen auf Fullerenen bedeutet quasi eine tangentiale Anordnung der Graphene auf den Fullerenen. Eine orthogonale Anordnung von Fullerenen auf Kohlenstoff-Nanoröhren kann man sich wie ein Zepter vorstellen, wobei das Fulleren an einem Ende einer Kohlenstoff-Nanoröhre sitzt.
Das Metallband besitzt vorzugsweise eine Dicke von 0,06 bis 3 mm, besonders bevorzugt von 0,08 bis 2,7 mm.
Gegenstand der Erfindung ist auch ein Verfahren zur Herstellung eines mit Kohlenstoff-Nanoröhren und/oder Fullerenen und Metall beschichteten Metallbandes umfassend die Schritte des
a) Beschichtens eines Metallbandes mit einer Diffusionssperrschicht,
b) Aufbringens einer keimbildenden Schicht auf die Diffusionssperrschicht,
c) Unterwerfens des nach Schritt a) und b) behandelten Metallbandes einer organische, gasförmige Verbindungen enthaltenden Atmosphäre,
d) Bildens von Kohlenstoff-Nanoröhren und/oder Fullerenen auf dem Metallband bei einer Temperatur von 200 °C bis 1500 °C,
e) Durchdringens der Kohlenstoff-Nanoröhren und/oder Fullerene mit einem Metall und
f) Einbringens von Graphene in die Beschichtung, wobei die Graphene orthogonal auf den Kohlenstoff-Nanoröhren und/oder Fullerenen angeordnet werden, oder die Graphene und/oder Fullerene orthogonal auf den Kohlenstoff-Nanoröhren angeordnet werden.
In dem erfindungsgemäßen Verfahren ist es bevorzugt, dass das Metallband beidseitig mit der Diffusionssperrschicht beschichtet wird. Auf die Diffusionssperrschicht wird vorteilhaft eine keimbildende Schicht aufgebracht, welche das säulenartige Auswachsen der Kohlenstoff-Nanoröhren bzw. das Abscheiden von Fullerenen unterstützt. Die keimbildende Schicht, die in dem Verfahren verwendet wird, umfasst bevorzugt ein Metallsalz, ausgewählt aus Metallen der Fe-Gruppe, der 8., 9. und 10. Nebengruppe des Periodensystems der Elemente.
Das so behandelte Metallband wird anschließend einer Atmosphäre ausgesetzt, die vorzugsweise eine Kohlenwasserstoffatmosphäre ist. Besonders bevorzugt ist die Kohlenwasserstoffatmosphäre einer Methanatmosphäre, wobei ferner der Atmosphäre bzw. Kohlenwasserstoffatmosphäre ein Trägergas zugesetzt wird. Als Trägergas kann beispielsweise Argon dienen.
Das Bilden der Kohlenstoff-Nanoröhren und/oder Fullerene auf dem Metallband erfolgt gewöhnlich bei einer Temperatur von 200 °C bis 1500 °C. Bei einer Temperatur von 200 °C bis 900 °C bilden sich vorwiegend mehrwandige Kohlenstoff-Nanoröhren (MWCNTs). Bei einer Temperatur größer 900 °C bis etwa 1500 °C werden bevorzugt einwandige Kohlenstoff-Nanoröhren (SWCNTs) gebildet. Die Qualität der Kohlenstoff-Nanoröhren kann verbessert werden, wenn das Wachstum in einer feuchten Umgebung erfolgt. Die Bildung der Kohlenstoff-Nanoröhren auf dem Metallband erfolgt säulenförmig, was durch die keimbildende Schicht unterstützt wird. Die Fullerene scheiden sich bevorzugt kugelförmig auf dem Metallband ab.
Anschließend erfolgt noch ein Durchdringen der Kohlenstoff-Nanoröhren und/oder Fullerene mit einem Metall. Als Metalle dienen die bereits oben genannten Metalle Sn, Ni, Ag, Au, Pd, Cu oder W sowie ihre Legierungen.
Die Durchdringung der Kohlenstoff-Nanoröhren und/oder Fullerene mit dem Metall erfolgt vorzugsweise über ein Vakuumverfahren, beispielsweise CVD (chemical vapour deposition) oder PVD (physical vapour deposition), elektrolytisch, stromlos reduktiv oder durch Einschmelzen/Infiltrieren. Es werden in die Beschichtung auch Graphene eingebracht. Bevorzugt bilden die Graphene und/oder Kohlenstoff-Nanoröhren und/oder Fullerenen ein Komposit. Das bedeutet, dass die Graphene mit Kohlenstoff-Nanoröhren, die Graphene mit Fullerenen, die Fullerene mit Kohlenstoff-Nanoröhren oder alle drei Komponenten zusammen ein Komposit bilden können. Besonders bevorzugt werden die Graphene orthogonal auf den Kohlenstoff-Nanoröhren und/oder Fullerenen angeordnet, wobei sie beispielsweise den Abschluss einer Röhre in axialer Richtung darstellen, oder die Graphene und Fullerene werden orthogonal auf den Kohlenstoff-Nanoröhren angeordnet. Eine orthogonale Anordnung von Graphenen auf Fullerenen bedeutet quasi eine tangentiale Anordnung der Graphene auf den Fullerenen. Eine orthogonale Anordnung von Fullerenen auf Kohlenstoff-Nanoröhren kann man sich wie ein Zepter vorstellen, wobei das Fulleren an einem Ende einer Kohlenstoff-Nanoröhre sitzt.

Ein so hergestelltes mit Metall und Kohlenstoff-Nanoröhren und/oder Fullerenen (und Graphenen) beschichtetes Metallband zeichnet sich durch einen verbesserten Reibwert, einen guten Kontaktübergangswiderstand, eine gute Verschleißbeständigkeit und eine gute Umformbarkeit aus und eignet sich somit hervorragend als elektromechanisches Bauteil, beispielsweise für Steckverbinder, Schalter, Relaisfedern oder dergleichen. Insbesondere in Kombination mit Graphenen in Form des oben beschriebenen Komposits kann eine elektrische und thermische Leitfähigkeit in horizontaler und vertikaler Richtung bereitgestellt werden, was besonders vorteilhaft ist.

## Patentansprüche

1. Metallband, umfassend eine Beschichtung aus Kohlenstoff-Nanoröhren, und/oder Fullerenen und Metall, die Kohlenstoff-Nanoröhren und/oder Fullerene mit einem Metall durchdrungen sind, das aus der Gruppe umfassend Sn, Ni, Ag, Au, Pd, Cu, W oder deren Legierungen ausgewählt ist; **dadurch gekennzeichnet, dass** die Beschichtung Graphene enthält, wobei die Graphene und/oder Fullerene orthogonal auf den Kohlenstoff-Nanoröhren angeordnet sind, oder die Graphene orthogonal auf den Kohlenstoff-Nanoröhren und/oder Fullerenen angeordnet sind.

2. Metallband nach Anspruch 1, ferner umfassend eine Diffusionssperrschicht auf beiden Seiten des Metallbandes.

3. Metallband nach Anspruch 2, **dadurch gekennzeichnet, dass** die Diffusionssperrschicht ein Nicht-Isolator ist.

4. Metallband nach Anspruch 2 oder 3, **dadurch gekennzeichnet, dass** die Diffusionssperrschicht ein Übergangsmetall umfasst.

5. Metallband nach einem der vorhergehenden Ansprüche, **dadurch gekennzeichnet, dass** die Kohlenstoff-Nanoröhren säulenartig auf dem Metallband angeordnet sind.

6. Metallband nach einem der vorhergehenden Ansprüche, **dadurch gekennzeichnet, dass** die Kohlenstoff-Nanoröhren einwandige oder mehrwandige Kohlenstoff-Nanoröhren sind.

7. Metallband nach einem der vorhergehenden Ansprüche, **dadurch gekennzeichnet, dass** das Metallband eine Dicke von 0,06 bis 3 mm aufweist.

8. Metallband nach einem der Ansprüche 1 bis 7, **dadurch gekennzeichnet, dass** die Graphene und/oder Kohlenstoff-Nanorohren und/oder Fullerene ein Komposit bilden.

9. Metallband nach einem der Ansprüche 1 bis 8, **dadurch gekennzeichnet, dass** das Metallband vorgestanzt ist.

10. Verfahren zur Herstellung eines mit Kohlenstoff-Nanoröhren und/oder Fullerenen und Metall beschichteten Metallbandes nach einem der Ansprüche 1 bis 9 umfassend die Schritte des
a. Beschichtens eines Metallbandes mit einer Diffusionssperrschicht,
b. Aufbringens einer keimbildenden Schicht auf die Diffusionssperrschicht,
c. Unterwerfens des nach Schritt a) und b) behandelten Metallbandes einer organische, gasförmige Verbindungen enthaltenden Atmosphäre,
d. Bildens von Kohlenstoff-Nanoröhren und/oder Fullerenen auf dem Metallband bei einer Temperatur von 200 °C bis 1500 °C,
e. Durchdringens der Kohlenstoff-Nanoröhren und/oder Fullerene mit einem Metall, und
f. Einbringens von Graphene in die Beschichtung, wobei die Graphene orthogonal auf den Kohlenstoff-Nanoröhren und/oder Fullerenen angeordnet werden, oder die Graphene und/oder Fullerene orthogonal auf den Kohlenstoff-Nanoröhren angeordnet werden.

11. Verfahren nach Anspruch 10, **dadurch gekennzeichnet, dass** das Metallband beidseitig mit der Diffusionssperrschicht beschichtet wird.

12. Verfahren nach Anspruch 10 oder 11, **dadurch gekennzeichnet, dass** als keimbildende Schicht ein Metallsalz, ausgewählt aus Metallen der Fe- Gruppe, der 8., der 9. oder der 10. Nebengruppe des Periodensystems der Elemente, verwendet wird.

13. Verfahren nach einem der Ansprüche 10 bis 12, **dadurch gekennzeichnet, dass** die keimbildende Schicht partiell aufgebracht wird (partielle Beschichtung).

14. Verfahren nach einem der Ansprüche 10 bis 13, **dadurch gekennzeichnet, dass** das Metallband einer Kohlenwasserstoffatmosphäre ausgesetzt wird.

15. Verfahren nach Anspruch 14, **dadurch gekennzeichnet, dass** neben der Kohlenwasserstoffatmosphäre ein Trägergas eingesetzt wird.

16. Verfahren nach einem der Ansprüche 10 bis 15, **dadurch gekennzeichnet, dass** das Metallband einer Atmosphäre mit einer organischen, gasförmigen Verbindung mit einem Feuchtgehalt von 50 - 90% unterworfen wird.

17. Verfahren nach einem der Ansprüche 10 bis 17, **dadurch gekennzeichnet, dass** die Temperatur zur Bildung der Kohlenstoff- Nanoröhren und/oder Fullerene 200 °C bis 900 °C beträgt.

18. Verfahren nach Anspruch 17, **dadurch gekennzeichnet, dass** mehrwandige Kohlenstoff-Nanoröhren (MWCNTs) gebildet werden.

19. Verfahren nach einem der Ansprüche 10 bis 16, **dadurch gekennzeichnet, dass** die Temperatur zur Bildung der Kohlenstoff-Nanoröhren und/oder Fullerene > 900 °C bis 1500 °C beträgt.

20. Verfahren nach Anspruch 19, **dadurch gekennzeichnet, dass** einwandige Kohlenstoff-Nanoröhren (SWCNTs) gebildet werden.

21. Verfahren nach einem der Ansprüche 10 bis 20, **dadurch gekennzeichnet, dass** die Bildung der Kohlenstoff-Nanoröhren säulenförmig auf dem Metallband erfolgt.

22. Verfahren nach einem der Ansprüche 10 bis 21, **dadurch gekennzeichnet, dass** die Durchdringung der Kohlenstoff-Nanoröhren und/oder Fullerene mit dem Metall über ein Vakuumverfahren, elektrolytisch, stromlos reduktiv oder durch Einschmelzen/Infiltrieren erfolgt.

23. Verfahren nach einem der Ansprüche 10 bis 22, **dadurch gekennzeichnet, dass** die Graphene und/oder Kohlenstoff-Nanoröhren und/oder Fullerenen ein Komposit bilden.

24. Verwendung eines Metallbandes nach einem der Ansprüche 1 bis 9 oder hergestellt nach einem Verfahren nach einem der Ansprüche 10 bis 23 als elektromechanisches Bauelement oder Stanzgitter.

## Claims

1. A metal strip, comprising a coating of carbon nanotubes, and/or fullerenes and metal, the carbon nanotubes and/or fullerenes are permeated with a metal selected from the group consisting of Sn, Ni, Ag, Au, Pd, Cu, W or alloys thereof, **characterized in that** the coating contains graphenes, wherein the graphenes and/or fullerenes are arranged orthogonally on the carbon nanotubes, or the graphenes are arranged orthogonally on the carbon nanotubes and/or fullerenes.

2. The metal strip according to claim 1, further comprising a diffusion barrier layer on both sides of the metal strip.

3. The metal strip according to claim 2, **characterized in that** the diffusion barrier layer is a non-insulator.

4. The metal strip according to claim 2 or 3, **characterized in that** the diffusion barrier layer comprises a transition metal.

5. The metal strip according to one of the preceding claims, **characterized in that** the carbon nanotubes are arranged on the metal strip in a columnar manner.

6. The metal strip according to one of the preceding claims, **characterized in that** the carbon nanotubes are single-wall or multi-wall carbon nanotubes.

7. The metal strip according to one of the preceding claims, **characterized in that** the metal strip has a thickness from 0.06 mm to 3 mm.

8. The metal strip according to one of claims 1 to 7, **characterized in that** the graphenes and/or carbon nanotubes and/or fullerenes form a composite.

9. The metal strip according to one of claims 1 to 8, **characterized in that** the metal strip is prepunched.

10. A method for producing a metal strip coated with carbon nanotubes and/or fullerenes and metal, according to one of claims 1 to 9, comprising the steps of:
a. coating a metal strip with a diffusion barrier layer,
b. applying a nucleation layer to the diffusion barrier layer,
c. exposing the metal strip treated according to step a) and b) to an atmosphere containing organic gaseous compounds,
d. forming carbon nanotubes and/or fullerenes on the metal strip at a temperature from 200°C to 1500°C,
e. permeating the carbon nanotubes and/or fullerenes with a metal, and
f. introducing graphenes into the coating, wherein the graphenes are arranged orthogonally on the carbon nanotubes and/or fullerenes, or the graphenes and/or fullerenes are arranged orthogonally on the carbon nanotubes.

11. The method according to claim 10, **characterized in that** the metal strip is coated on both sides with the diffusion barrier layer.

12. The method according to claim 10 or 11, **characterized in that** a metal salt selected from metals of the Fe group, the 8^{th}, the 9^{th} or the 10^{th} subgroup of the periodic table of the elements is used as the nucleation layer.

13. The method according to one of claims 10 to 12, **characterized in that** the nucleation layer is applied partially (partial coating).

14. The method according to one of claims 1 to 13, **characterized in that** the metal strip is exposed to a hydrocarbon atmosphere.

15. The method according to claim 14, **characterized in that** a carrier gas is used in addition to the hydrocarbon atmosphere.

16. The method according to one of claims 10 to 15, **characterized in that** the metal strip is exposed to an atmosphere with an organic gaseous compound with a moisture content of 50-90%.

17. The method according to one of claims 10 to 17, **characterized in that** the temperature for forming the carbon nanotubes and/or fullerenes is 200°C to 900°C.

18. The method according to claim 17, **characterized in that** multi-wall carbon nanotubes (MWCNTs) are formed.

19. The method according to one of claims 10 to 16, **characterized in that** the temperature for forming the carbon nanotubes and/or the fullerenes is >900°C to 1500°C.

20. The method according to claim 19, **characterized in that** single-wall carbon nanotubes (SWCNTs) are formed.

21. The method according to one of claims 10 to 20, **characterized in that** the carbon nanotubes are formed on the metal strip in a columnar manner.

22. The method according to one of claims 10 to 21, **characterized in that** the carbon nanotubes and/or fullerenes are permeated with the metal by way of a vacuum process, electrolytically, in an electroless reductive manner, or by melting/infiltration.

23. The method according to one of claims 10 to 22, **characterized in that** the graphenes and/or carbon nanotubes and/or fullerenes form a composite.

24. Use of a metal strip according to one of claims 1 to 9 or produced according to a method according to one of claims 10 to 23 as an electromechanical component or lead frame.

## Revendications

1. Bande métallique, comprenant un revêtement en nanotubes de carbone et/ou en fullerènes et en métal,
un métal choisi dans le groupe comprenant Sn, Ni, Ag, Au, Pd, Cu, W ou des alliages de ces métaux diffuse à travers les nanotubes de carbone et/ou les fullerènes,
**caractérisée en ce que**
le revêtement contient des graphènes, les graphènes et/ou les fullerènes étant disposés de manière orthogonale sur les nanotubes de carbone ou les graphènes étant disposés de manière orthogonale sur les nanotubes de carbone et/ou les fullerènes.

2. Bande métallique selon la revendication 1, comprenant en outre une couche barrière de diffusion sur les deux côtés de la bande métallique.

3. Bande métallique selon la revendication 2, **caractérisée en ce que** la couche barrière de diffusion est un non isolant.

4. Bande métallique selon la revendication 2 ou 3, **caractérisée en ce que** la couche barrière de diffusion comprend un métal de transition.

5. Bande métallique selon l'une des revendications précédentes, **caractérisée en ce que** les nanotubes de carbone sont disposés en colonnes sur la bande métallique.

6. Bande métallique selon l'une des revendications précédentes, **caractérisée en ce que** les nanotubes de carbone sont des nanotubes de carbone à paroi simple ou à parois multiples.

7. Bande métallique selon l'une des revendications précédentes, **caractérisée en ce que** la bande métallique a une épaisseur de 0,06 mm à 3 mm.

8. Bande métallique selon l'une des revendications 1 à 7, **caractérisée en ce que** les graphènes et/ou les nanotubes de carbone et/ou les fullerènes forment un composite.

9. Bande métallique selon l'une des revendications 1 à 8, **caractérisée en ce que** la bande métallique est pré-estampée.

10. Procédé de fabrication d'une bande métallique revêtue de nanotubes de carbone et/ou de fullerènes et de métal selon l'une des revendications 1 à 9, comprenant les étapes de
a. revêtement d'une bande métallique avec une couche barrière de diffusion,
b. application d'une couche de germination sur la couche barrière de diffusion,
c. soumission de la bande métallique traitée selon les étapes a) et b) à une atmosphère contenant des composés organiques gazeux,
d. formation de nanotubes de carbone et/ou de fullerènes sur la bande métallique à une température comprise entre 200°C et 1 500°C,
e. diffusion d'un métal à travers les nanotubes de carbone et/ou les fullerènes, et
f. introduction de graphènes dans le revêtement, les graphènes étant disposés de manière orthogonale sur les nanotubes de carbone et/ou les fullerènes ou les graphènes et/ou les fullerènes étant disposés de manière orthogonale sur les nanotubes de carbone.

11. Procédé selon la revendication 10, **caractérisé en ce que** la bande métallique est revêtue de la couche barrière de diffusion sur les deux côtés.

12. Procédé selon la revendication 10 ou 11, **caractérisé en ce que** l'on utilise, en tant que couche de germination, un sel métallique choisi parmi les métaux du groupe Fe, du sous-groupe 8, du sous-groupe 9 ou du sous-groupe 10 de la classification périodique des éléments.

13. Procédé selon l'une des revendications 10 à 12, **caractérisé en ce que** la couche de germination est appliquée de manière partielle (revêtement partiel).

14. Procédé selon l'une des revendications 10 à 13, **caractérisé en ce que** la bande métallique est exposée à une atmosphère d'oxygène.

15. Procédé selon la revendication 14, **caractérisé en ce qu'**un gaz vecteur est utilisé en plus de l'atmosphère d'oxygène.

16. Procédé selon l'une des revendications 10 à 15, **caractérisé en ce que** la bande métallique est soumise à une atmosphère contenant un composé organique gazeux, ayant une humidité de 50% à 90%.

17. Procédé selon l'une des revendications 10 à 17, **caractérisé en ce que** la température de formation des nanotubes de carbone et/ou des fullerènes est comprise entre 200°C et 900°C.

18. Procédé selon la revendication 17, **caractérisé en ce que** des nanotubes de carbone à parois multiples (soit MWCNT, *multi-wall carbon nanotubes*) sont formés.

19. Procédé selon l'une des revendications 10 à 16, **caractérisé en ce que** la température de formation des nanotubes de carbone et/ou des fullerènes est supérieure à 900°C et peut atteindre 1 500°C.

20. Procédé selon la revendication 19, **caractérisé en ce que** des nanotubes de carbone à paroi simple (soit SWCNT, *single-wall carbon nanotubes*) sont formés.

21. Procédé selon l'une des revendications 10 à 20, **caractérisé en ce que** la formation des nanotubes de carbone se produit en colonnes sur la bande métallique.

22. Procédé selon l'une des revendications 10 à 21, **caractérisé en ce que** la diffusion du métal à travers les nanotubes de carbone et/ou les fullerènes s'effectue au moyen d'un procédé sous vide, par voie électrolytique, par réduction sans courant ou par fusion/infiltration.

23. Procédé selon l'une des revendications 10 à 22, **caractérisé en ce que** les graphènes et/ou les nanotubes de carbone et/ou les fullerènes forment un composite.

24. Utilisation d'une bande métallique selon l'une des revendications 1 à 9 ou fabriquée suivant un procédé selon l'une des revendications 10 à 23 en tant que composant électromécanique ou grille estampée.
